Europäisches Patentamt

European Patent Office

Office européen des brevets

(11) Veröffentlichungsnummer: **0 363 947**
**A2**

## EUROPÄISCHE PATENTANMELDUNG

(21) Anmeldenummer: **89118941.7**

(51) Int. Cl.5: **H03H 11/20**

(22) Anmeldetag: **12.10.89**

(30) Priorität: **13.10.88 DE 3834843**

(43) Veröffentlichungstag der Anmeldung:
**18.04.90 Patentblatt 90/16**

(84) Benannte Vertragsstaaten:
**DE FR GB NL SE**

(71) Anmelder: **Kramer, Günter**
**Falkenring 4a**
**D-3303 Vechelde(DE)**

(72) Erfinder: **Kramer, Günter**
**Falkenring 4a**
**D-3303 Vechelde(DE)**

(54) **Phasenschieber für Taktsignale.**

(57) Der elektronische kontinuierlich zyklisch arbeitende Phasenschieber ist insbesondere für die Anwendung auf Taktsignale in Phasenfolgeempfängern für Navigationszwecke geeignet und weist folgende Merkmale auf:

a) einen Phasenaufspalter (1), der das Eingangs-Taktsignal in wenigstens zwei zueinander phasenverschobene Zwischen-Taktsignale, aufspaltet,

b) eine Kombinierstufe, in der - z.B. mittels Multipliziergliedern (2,3) und einer Summierstufe (4) -eine steuerbare Linearkombination der Zwischen-Taktsignale gebildet wird, und

c) ein auf die Taktfrequenz abgestimmtes Resonanzfilter (5).

Die zyklische Arbeitsweise ermöglicht einen prinzipiell unbegrenzten Verstellbereich, wobei die Einstellunsicherheit für die Phasenzeit auf Bruchteile einer Nanosekunde begrenzt werden kann.

EP 0 363 947 A2

Fig.1

## Phasenschieber für Taktsignale

Die Erfindung betrifft einen Phasenschieber für Taktsignale, insbesondere fir Phasenfolgeempfänger für Navigationszwecke. In Empfängern der Hyperbel-Navigation wird zur Erzielung eines ausreichenden Signal-zu-Rausch-Verhältnisses allgemein ein Korrelationsverfahren angewandt. Dabei wird im Empfänger ein Vergleichssignal erzeugt und mit dem Empfangssignal verglichen. Die Phase des Vergleichssignals wird dann in einem Regelkreis so nachgeführt, daß eine bestimmte Korrelation erreicht und gehalten wird. Die zu verfolgende Signatur des Signals kann die Trägerphase selbst und/oder eine Modulation sein.

Zur Erzeugung des Vergleichssignals sind spannungsgesteuerte Oszillatoren (VCO), mechanisch rotierende Drehfeldsysteme oder auch Einfügungen oder Eliminierungen einzelner Taktimpulse angewandt worden. Die verwendeten Systeme weisen bei der Anwendung alle Nachteile auf, die in einer maximalen oder minimalen Verstellgeschwindigkeit oder in einer unzureichenden Phasenzeit-Auflösung bestehen. Bei der Verwendung eines spannungsgesteuerten Oszillators ist für die Feststellung der Phasenzeit eine zusätzliche Meßeinrichtung erforderlich.

Der Erfindung liegt demgegenüber die Aufgabe zugrunde, einen Phasenschieber für Taktsignale zu erstellen, der eine schnelle und einfache Phasenverschiebung und eine Feststellung der Phasenzeit als Maß der Phasenverschiebung ohne Zusatzmaßnahmen erlaubt.

Diese Aufgabe wird erfindungsgemäß mit einem Phasenschieber gelöst, der besteht aus

a) einem Phasenaufspalter, der aus einem Taktsignal u0 zwei oder mehr gegeneinander phasenverschobene Zwischen-Taktsignale (u1,u2,...) erzeugt.

b) einer Kombinierstufe, die aus diesen eine steuerbare Linearkombination (ua = a1•u1 + a2•u2 + ....) bildet, wobei die Steuergrößen (a1,a2,..) dieser Kombinierstufe als analog veränderliche Signale oder in digitaler Repräsentation zugeführt werden, und

c) einem auf die Taktfrequenz abgestimmten Resonanzfilter, das aus dem Ausgangssignal (ua) der Kombinierstufe ein Sinussignal herausfiltert, dessen Nulldurchgänge den gesteuert Phasenverschobenen Takt repräsentieren.

Bekannt sind an sich Phasenschieber, die die trigonometrische Identität cos(ωt-φ) = cosωt•cosφ + sinωt•sinφ elektrisch nachbilden. (s.zB. US-Pat. 3517323)

Die Anwendung dieses Prinzips wurde bisher durch zwei Nachteile der bekannten oder naheliegenden Ausführungen erschwert:

1) Multiplizierer, die das Produkt zweier feinstufig veränderlicher Signale bilden, sind aufwendig und auf vergleichsweise niedrige Frequenzen beschränkt.

2) Will man die Frequenz des phasenverschobenen Takt-Signals durch Periodenzählung teilen, so darf die Phasenverschiebung φ im allgemeinen nicht sprunghaft verändert werden, da sonst zusätzliche Nulldurchgänge entstehen können, die die Periodenzählung verfälschen.

Die Erfindung beseitigt diese beiden Nachteile durch eine einzige Maßnahme, nämlich die Hinzufügung eines auf die Taktfrequenz abgestimmten Resonanzfilters als Bandpaß am Ausgang des Phasenschiebers.

Die Kombinierstufe erzeugt eine Linearkombination der Zwischen-Taktsignale. Diese brauchen nun keine Sinus-Signale zu sein sondern können beliebige periodische Funktionen sein. Die Herausfilterung einer einzigen Fourier-Komponente wirkt in Verbindung mit der Linearität genauso, als wären alle Zwischen-Taktsignale Sinus-Signale. Entsprechend läßt sich die mit einem bestimmten Satz von Steuergrößen (a1,a2,...) bewirkte Phasenverschiebung leicht nach den Rechenregeln der Trigonometrie vorhersagen. Bevorzugte Signalform ist natürlich die Rechteckform.

Führt man die Steuergrößen (a1,a2,...) in Form analog veränderlicher Signale zu, also z B. a1 = cosφ; a2 = sinφ, so bedeutet dies, daß zur Bildung der Produktterme a1•u1, a2•u2, ... Doppel-Gegentakt-Modulatoren eingesetzt werden können.

Der Phasenaufspalter kann für Rechteck-Signale aus Verzögerungsstufen bestehen. Liegt der gewünschte Phasenwinkel in digitaler Verschlüsselung vor, so kann auch die Kombinierstufe ganz überwiegend aus logischen Schaltkreisen aufgebaut werden. Beispielsweise kann im Phasenaufspalter eine Reihe vorzugsweise gleichmäßig über die Periode verteilter Zwischentakt-Signale erzeugt werden, von denen mit einem sogenannten Multiplexer-Baustein jeweils eines ausgewählt wird. Man kann auch zwei zeitlich benachbarte Zwischen-Taktsignale auswählen und mittels eines Einfachst-Digital/Analog-Wandlers zwischen diesen interpolieren.

In einer sehr simplen Ausführungsform, die eine Steuerung nur für vier Phasen erlaubt, werden als Steuersignale lediglich die Vorzeichenfunktionen sign(cosφ) und sign(sinφ) verwendet.

Die Schwungrad-Wirkung des Resonanzkreises stellt sicher, daß auch bei sprunghafter Änderung der Steuergröße φ die Ausgangsphase kontinuierlich in den neuen Wert übergeht. Die Zeitpunkte, zu denen die Phasenschritte ausgeführt werden, brauchen dabei in keiner Weise mit dem Taktsignal synchronisiert zu sein. Führt man zum Beispiel vier Phasenschritte von jeweils einer Viertelperiode in die gleiche Richtung aus, so wird in einem gegebenen (die Schritte umfassenden) Zeitraum das Ausgangssignal einen Nulldurchgang also gewissermaßen eine Periode mehr (bzw. weniger) aufweisen, als das Eingangssignal des Phasenschiebers. Mit dem erfindungsgemäßen Phasenschieber läßt sich also nicht nur die Phasendifferenz zwischen Ausgangs- und Eingangs-Signal einstellen, sondern eine Reihe von Phasenschritten akkumulieren. Die akkumulierte Phase kann viele Perioden betragen. Der Betrag eines Phasenschritts sollte dabei nicht viel größer als 90° sein, da die Richtung eines 180°-Schritts unbestimmt ist. (Die Schwingungsamplitude des Resonanzfilters ginge dabei durch Null.)

Ein breitbandiger Phasenaufspalter, der in einem weiten Frequenzbereich zwei um 90° phasenverschobene Signale erzeugt kann aus einer Signalverzweigung gebildet sein, deren einer Zweig einen Serienwiderstand (R1) und einen gegen Masse geschalteten Kondensator (C1) und deren anderer Zweig einen Serienkondensator (C2) und einen gegen Masse geschalteten Widerstand (R2) aufweist, wobei gilt $R1 \cdot C1 = R2 \cdot C2 \approx 1/\omega$, und bei dem die Ausgangssignale der Signalverzweigung einer Amplitudenbegrenzung unterzogen werden.

Werden analoge Steuersignale entsprechend $\cos\phi$ und $\sin\phi$ verwandt, so läßt sich eine Genauigkeit des Phasenschiebers von Bruchteilen eines Grads erzielen. Die typischen Unvollkommenheiten des Phasenaufspalters und der Modulatoren lassen sich dadurch kompensieren, daß korrigierte Steuersignale verwendet werden, die aus den ursprünglichen Steuersignalen durch einstellbare Nullpunktverschiebung, Veränderung der relativen Größe und Kreuzkopplung gewonnen werden, und daß zum Abgleich der Einstellpotentiometer die Steuergröße über eine Periode variiert und dabei die Konstanz der Amplitude des gefilterten Ausgangssignals kontrolliert wird.

Die Erfindung soll im folgenden anhand von in der Zeichnung dargestellten Ausführungsbeispielen näher erläutert werden. Es zeigen:

Figur 1 - ein Blockschaltbild eines elektronischen Phasenschiebers

Figur 2 - ein Blockschaltbild eines Navigationsempfängers mit einem Phasenschieber gemäß Figur 1.

Figur 3 - ein Prinzipschaltbild eines Multiplizierers

Figur 4 - ein Ausführungsbeispiel eines einfachen Phasenaufspalters für zwei um 90° zueinander phasenverschobene Signale

Figur 5 - einen Phasenschieber mit einer direkten digitalen Steuerung

Figur 6 - ein Ausführungsbeispiel für das Prinzip gemäß Figur 5 mit einer Einfachst-Digital/Analog-Wandlung.

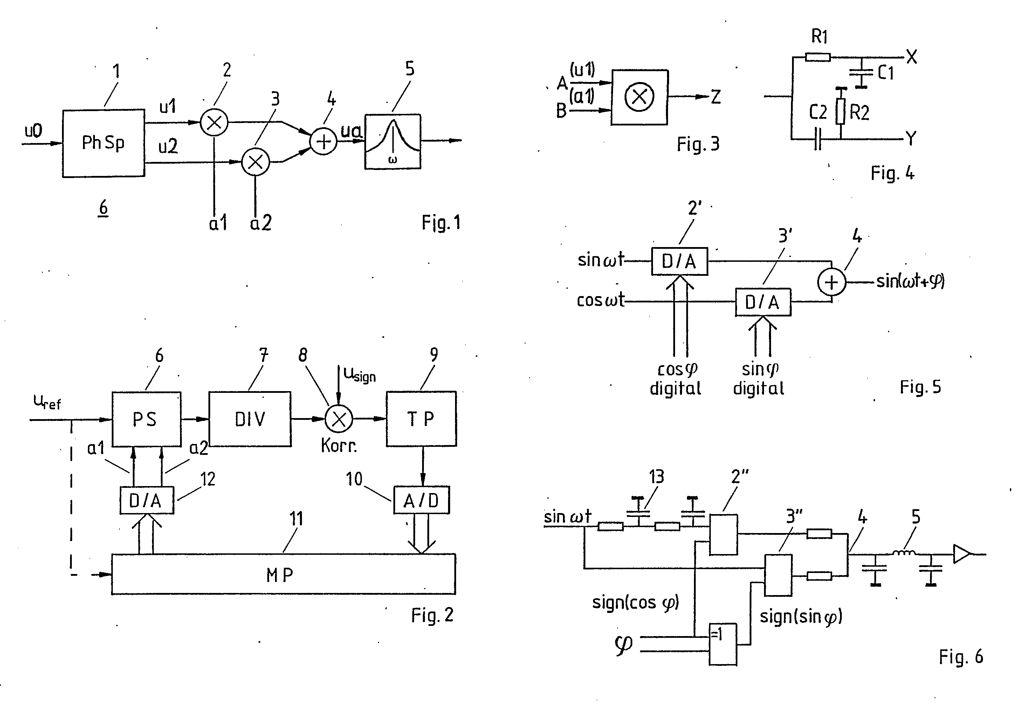

In Figur 1 gelangt die Eingangsspannung u0 auf einen Phasenaufspalter 1, der zwei zueinander Phasenverschobene Signale u1 und u2 erzeugt. Im beschriebenen Spezialfall ist die Eingangsspannung eine Sinusfunktion $\sin\omega t$, so daß die Ausgangssignale des Phasenaufspalters 1 $\sin\omega t$ und $\cos\omega t$ sind. Die beiden zueinander Phasenverschobenen Signale u1 und u2 gelangen auf jeweils einen Multiplizierer 2, 3, an dessen anderem Eingang ein Steuersignal a1 bzw. a2 ansteht. Die Ausgangssignale der beiden Multiplizierer 2, 3 gelangen auf eine Additionsstufe 4, an die sich ein Resonanzfilter 5 anschließt, das auf die Arbeitsfreguenz $\omega$ des Taktsignals eingestimmt ist. Im beschriebenen Fall, in dem $u1 = \cos\omega t$ und $u2 = \sin\omega t$ sind, gilt $a1 = \cos\phi$ und $a2 = \sin\phi$ wobei $\phi$ die gewünschte Phasenverschiebung darstellt.

Das Resonanzfilter 5 erlaubt die Verwendung von Rechtecksignalen bei der Arbeitsfreguenz $\omega$ und die Verwendung eines Doppel-Gegentakt-Mischers als Multiplizierer, wie unten noch erläutert werden wird. Das Filter sorgt weiterhin dafür, daß evtl. Phasensprünge zeitlich verteilt werden, so daß ein nachgeschalteter Frequenzteiler keine Fehlzählungen ausführt.

Bei dem erfindungsgemäßen Phasenschieber können Phasenschritte bis zu ca. 90° verarbeitet und sehr schnell ausgeführt werden. Eine Phasenzeitauflösung ist in der Größenordnung von Bruchteilen einer Nanosekunde realisierbar, was bei einem Navigationsempfänger einer Entfernungsauflösung von einigen Zentimetern entspricht.

Figur 2 zeigt einen mikroprozessorgesteuerten Phasenfolgeempfänger. Dessen Funktion beruht darauf, daß ein Referenzsignal Uref mit einem Meßsignal Usign korreliert wird, wobei das Referenzsignal der Phase des Meßsignals nachgeführt wird. Das Referenzsignal gelangt auf einen Phasenschieber 6, wie er in Figur 1 dargestellt ist. Ggf. nach einer Frequenzteilung im Frequenzteiler 7 gelangt das Referenzsignal Uref auf eine Korrelationsstufe 8, deren anderem Eingang das Meßsignal Usign zugeführt wird. Über einen Tiefpaß 9 und einen Analog/Digital-Wandler 10 gelangt das Korrelationssignal auf einen Mikroprozessor 11, der seinerseits über einen Digital/Analog-Wandler 12 das Maß der Phasenverschiebung in dem Phasenschieber 6 durch Erzeugung geeigneter Steuersignale a1, a2 herstellt.

Die für die Navigation interessante Differenz der Empfangszeiten oder -phasen kann dabei durch Mitzählen der Phasenschritte im Mikroprozessor ohne jeden zusätzlichen Aufwand ermittelt werden.

Anhand der Darstellung eines Multiplizierers 2 in Figur 3 soll erläutert werden daß die Verwendung von Vier-Quadranten Multiplizierern im vorliegenden Fall nicht erforderlich ist, sondern daß eine einfache und genaue Multiplikation mit Doppel-Gegentakt-Modulatoren verwendbar ist, die nur bezüglich einer Eingangsgröße linear sind. Bei dem dargestellten Modulator ist die Ausgangsgröße Z linear mit der Steuerspannung A, während bezüglich der Trägerspannung B ein nicht linearer Zusammenhang gilt:

$$Z = A \cdot f(B) .$$

f(B) ist eine antisymmetrische, nicht lineare Funktion, die bei starker Aussteuerung in eine reine Schaltfunktion übergeht, sodaß:

$$Z = A \cdot sign(B) .$$

Dadurch wird das Ausgangssignal Z unabhängig von der Amplitude des Träger-Eingangssignals B eine Rechteckfunktion, deren Amplitude jedoch sehr genau proportional zur Steuereingangsspannung A ist. Aus der Rechteckfunktion läßt sich durch ein einfaches Schwingungssieb ein proportionales Sinussignal herausfiltern. Im Gegensatz zu normalen Multiplizierern lassen sich Doppel-Gegentakt-Modulatoren auch für sehr hohe Frequenzen mit hoher Genauigkeit realisieren.

Figur 4 zeigt einen Phasenaufspalter, der für ein sinusförmiges Eingangssignal zwei zueinander um 90° Phasenverschobene Ausgangssignale ermöglicht.

Das Problem der Phasenaufspaltung besteht darin, daß sie regelmäßig frequenzabhängig ist. Die frequenzunabhängige Phasenaufspaltung in zwei um 90° verschobene Signale läßt sich nur näherungsweise, z.B. durch Zusammenschaltung mehrerer Allpässe, verwirklichen. Läßt man jedoch eine Frequenzabhängigkeit der Amplituden der Ausgangssignale zu, so läßt sich eine frequenzunabhängige Phasendifferenz mit der Anordnung gemäß Figur 4 erreichen. Bei der Anordnung, in der in einem Zweig ein RC-Glied R1, C1 und in dem anderen Zweig ein CR Glied C2, R2 vorhanden ist, ist die Phasen-differenz zwischen den Ausgangssignalen X und Y stets 90° unabhängig von der Eingangsfrequenz ω. Amplitudengleichheit herrscht jedoch nur für den Fall ω = 1/RC. Die Amplitudenabhängigkeit kann aber durch eine Begrenzung eliminiert werden, wie sie bei der Verwendung das anhand Figur 3 beschriebenen Doppel-Gegentakt-Modulators verwirklicht wird.

Die Steuerspannungen a1 und a2, wie sie in Figur 1 erläutert worden sind können in der Form sinφ und cosφ mittels eines Sinus-Cosinus-Potentiometers (s.z.B. DE 29 45 266 C2) durch Drehung eines einzigen Einstellknopfes erzeugt werden. Liegt die Steuergröße φ digital vor, so lassen sich die Steuerspannungen mittels spezieller Digital/Sinus-Cosinus-Wandler (s. z.B. DE 34 00 061 A1) erzeugen

Eine andere Möglichkeit, die Steuersignale a1 und a2 zu erzeugen, besteht darin aus einer abgespeicherten Tabelle für einen digital vorliegenden Winkel φ die digitalen Darstellungen von sinφ und cosφ zu entnehmen und mittels zweier D/A-Wandler in analoge Steuerspannungen umzusetzen.

Evtl. Ungenauigkeiten der Modulatoren und des Phasenaufspalters können durch die Steuerspannungen korrigiert werden.

Wenn φ die Steuergröße sein soll, läßt sich die wirkliche Phasendrehung als

$$\phi^1 = \phi + \Delta\phi (\phi)$$

darstellen.

Der Fehler $\Delta\phi$ ist als Periodische Funktion von φ darstellbar:

$$\Delta\phi = \phi A + \phi B \sin\phi + \phi C \cos\phi + \phi D \sin2\phi + \phi E \cos2\phi + ...$$

Die einzelnen Komponenten $\phi A ... \phi E$ lassen sich durch einige Einstellpotentiometer zur Nullpunktverschiebung ($\phi B$, $\phi C$), zur proportionalen Veränderung der relativen Größe ($\phi D$) und zur Kreuzkopplung ($\phi A$, $\phi E$) der Steuerspannungen zu Null machen. Dabei sind - außer für $\phi A$ -keine Phasenmessungen erforderlich. Abgleichkriterium ist, daß die Amplitude des gefilterten Ausgangssignals unabhängig vom Steuerwinkel φ ist. Dazu läßt man φ gleichmäßig variieren und stellt die Ausgangsspannung auf einem Oszilloskop dar, dessen Ablenkung mit φ synchronisiert ist. Die Wirkung der einzelnen Einstellpotentiometer ist dann unmittelbar ersichtlich.

Figur 5 zeigt eine Ausführungsform des erfindungsgemäßen Phasenschiebers mit einer direkten digitalen Steuerung. Die hinter dem Phasenaufspalter 1 stehenden Eingangsspannungen sinωt und cosωt gelangen auf multiplizierende D/A-Wandler 2', 3', denen die digitalen Werte für cosφ und sinφ direkt zugeführt werden. Am Ausgang der Additionsstufe 4 steht dann das gewünschte Signal sin(ωt + φ) an.

Eine einfache Variante des in Figur 5 dargestellten Prinzips ist in Figur 6 gezeigt. Das digitale Eingangssignal sinωt wird in einer Verzögerungsschaltung 13 um 90° verzögert und gelangt auf eine Multiplikationsstufe 2''. Das unverzögerte digitale Signal gelangt auf die zweite Multiplikationsstufe 3''. Den jeweils anderen Eingängen der beiden Multiplikationsstufen 2'', 3'' werden die Vorzeichenfunktionen sign(cosφ) und sign(sinφ) zugeführt. Auf diese Weise lassen sich insgesamt vier Phasen in einfacher Weise mit geringstem Schaltungsaufwand einstellen. Die Ausgangssignale der beiden Multiplizierer 2'' und 3'' gelangen über Widerstände an einen Summationspunkt, der den Addierer 4 bildet. Nachgeschaltet ist ein einfaches Resonanzfilter 5.

## Ansprüche

1) Phasenschieber für Taktsignale bestehend aus:

a) einem Phasenaufspalter, der aus einem Taktsignal u0 zwei oder mehr gegeneinander phasenverschobene Zwischen Taktsignale (u1,u2,...) erzeugt,

b) einer Kombinierstufe, die aus diesen eine steuerbare Linearkombination (ua = a1*u1 + a2*u2 + ....) bildet, wobei die Steuergrößen (a1,a2,..) dieser Kombinierstufe als analog veränderliche Signale oder in digitaler Repräsentation zugeführt werden, und

c) einem auf die Taktfrequenz $\omega$ abgestimmten Resonanzfilter, das aus dem Ausgangssignal (ua) der Kombinierstufe ein Sinussignal herausfiltert, dessen Nulldurchgänge den gesteuert phasenverschobenen Takt repräsentieren.

2) Phasenschieber nach Patentanspruch 1, bei dem im Phasenaufspalter als Zwischen-Taktsignale zwei gegeneinander um eine Viertelperiode Phasenverschobene periodische Signale (u1,u2) gebildet werden und die Steuergrößen (a1,a2) den Bedingungen a1 = cos$\phi$ ; a2 = sin$\phi$ genügen, wobei $\phi$ die gewünschte Phasendrehung repräsentiert.

3) Phasenschieber nach Patentanspruch 1, bei dem

a) eine Reihe von vorzugsweise äquidistant phasenverschobenen Zwischen-Taktsignalen erzeugt wird und

b) nur jeweils eine der Steuergrößen (a1,a2,...) von Null verschieden ist, wodurch die Kombinierstufe die Sonderform einer Auswahlstufe annimmt.

4) Phasenschieber nach Patentanspruch 1, bei dem

a) eine Reihe von vorzugsweise äquidistant phasenverschobenen Zwischen-Taktsignalen erzeugt wird und

b) nur jeweils zwei der Steuergrößen von Null verschieden sind, die mit zwei phasenzeitlich benachbarten Zwischen-Taktsignalen multipliziert werden, so daß die gebildete Linearkombination eine phasenmäßige Interpolation zwischen ausgewählten Zwischen-Taktsignalen darstellt.

5) Phasenschieber nach Anspruch 2, bei dem zur Bildung der Produktterme in der Kombinierstufe Doppel-Gegentakt-Modulatoren verwendet werden.

6) Phasenschieber nach Anspruch 1, bei dem der Phasenaufspalter aus einer Signalverzweigung gebildet ist, deren einer Zweig einen Serienwiderstand (R1) und einen gegen Masse geschalteten Kondensator (C1) und deren anderer Zweig einen Serienkondensator (C2) und einen gegen Masse geschalteten Widerstand (R2) aufweist, wobei gilt R1*C1 = R2*C2 ≈ 1/$\omega$, und bei dem die Ausgangssignale der Signalverzweigung einer Amplitudenbegrenzung unterzogen werden.

7) Phasenschieber nach Anspruch 2, bei dem als Steuergrößen (a1,a2) sign(cos$\phi$) und sign(sin$\phi$) verwendet werden.

8) Phasenschieber nach Anspruch 2, bei dem zum Abgleich des Phasenschiebers korrigierte Steuersignale verwendet werden, die aus den ursprünglichen Steuersignalen durch einstellbare Nullpunktverschiebung, Veränderung der relativen Größe und Kreuzkopplung gewonnen werden, und bei dem zum Abgleich der Einstellpotentiometer die Steuergröße über eine Periode variiert und dabei die Konstanz der Amplitude des gefilterten Ausgangssignals kontrolliert wird.

Fig. 1

Fig. 3

Fig. 4

Fig. 5

Fig. 2

Fig. 6

EP 0 363 947 A2